# FASCICULE DE BREVET EUROPEEN

(11) **EP 3 347 768 B1**
(45) Date de publication et mention de la délivrance du brevet: **24.07.2019**
(21) Numéro de dépôt: 16763793.3
(22) Date de dépôt: 09.09.2016
(51) Int. Cl.: G03F 7/00

(54) **PROCEDE DE GRAVURE SELECTIVE D'UN COPOLYMERE A BLOCS**
VERFAHREN ZUM SELEKTIVEN ÄTZEN EINES BLOCKCOPOLYMERS
METHOD FOR SELECTIVE ETCHING OF A BLOCK COPOLYMER

(30) Priorité: 11.09.2015 FR 1558481
(43) Date de publication de la demande: 18.07.2018
(73) Titulaire: Commissariat à l'Énergie Atomique et aux Énergies Alternatives, 75015 Paris (FR)
(72) Inventeur: POSSEME, Nicolas, 38360 Sassenage (FR); BARNOLA, Sébastien, 38190 Villard-Bonnot (FR); PIMENTA BARROS, Patricia, 38000 Grenoble (FR); SARRAZIN, Aurélien, 38000 Grenoble (FR)
(74) Mandataire: Cabinet Camus Lebkiri
(86) Numéro de dépôt international: PCT/EP2016/071267
(87) Numéro de publication internationale: WO 2017/042312

(56) Documents cités:
- EP-A2- 2 733 533
- WO-A1-2015/034600
- US-A1- 2011 147 337
- US-A1- 2012 127 454
- US-A1- 2015 225 601
- US-B1- 6 565 763

## Description

### DOMAINE TECHNIQUE

La présente invention est relative aux techniques d'auto-assemblage dirigé de copolymères à blocs (« Directed Self-Assembly », DSA) permettant de générer des motifs de très hautes résolution et densité. L'invention concerne plus particulièrement un procédé de gravure permettant de retirer une première phase d'un copolymère à blocs sélectivement par rapport à une deuxième phase du copolymère à blocs.

### ÉTAT DE LA TECHNIQUE

La limite de résolution de la lithographie optique conduit à explorer de nouvelles techniques pour réaliser des motifs dont la dimension critique (CD) est inférieure à 22 nm. L'auto-assemblage dirigé de copolymères à blocs est considéré comme l'une des techniques de lithographie émergentes les plus prometteuses, en raison de sa simplicité et du faible coût de sa mise en oeuvre.

Les copolymères à blocs sont des polymères dans lesquels deux unités de répétition, un monomère A et un monomère B, forment des chaînes liées entre elles par une liaison covalente. Lorsque l'on donne suffisamment de mobilité aux chaînes, par exemple en chauffant ces copolymères à blocs, les chaînes de monomère A et les chaînes de monomère B ont tendance à se séparer en phases ou blocs de polymère et à se réorganiser sous des conformations spécifiques, qui dépendent notamment du ratio entre le monomère A et le monomère B. En fonction de ce ratio, on peut avoir des sphères de A dans une matrice de B, ou bien des cylindres de A dans une matrice de B, ou encore des lamelles de A et des lamelles de B intercalées. La taille des domaines du bloc A (respectivement du bloc B) est directement proportionnelle à la longueur des chaînes du monomère A (respectivement du monomère B). Les copolymères à blocs ont donc la propriété de former des motifs de polymère qui peuvent être contrôlés grâce au ratio des monomères A et B.

Les techniques connues d'auto-assemblage de copolymères à blocs (DSA) peuvent être regroupées en deux catégories, la grapho-épitaxie et la chémo-épitaxie.

La grapho-épitaxie consiste à former des motifs primaires appelés guides à la surface d'un substrat, ces motifs délimitant des zones à l'intérieur desquelles une couche de copolymère à blocs est déposée. Les motifs de guidage permettent de contrôler l'organisation des blocs de copolymère pour former des motifs secondaires de plus haute résolution à l'intérieur de ces zones. Les motifs de guidage sont classiquement formés par photolithographie dans une couche de résine.

Dans les techniques DSA par chémo-épitaxie, le substrat subit une modification chimique de sa surface de manière à créer des zones attirant préférentiellement un seul bloc du copolymère, ou des zones neutres n'attirant préférentiellement aucun des deux blocs du copolymère. Ainsi, le copolymère à blocs ne s'organise pas de manière aléatoire, mais selon le contraste chimique du substrat. La modification chimique du substrat peut notamment être obtenue par le greffage d'une couche de neutralisation appelée « brosse » (« brush layer » en anglais), par exemple formée d'un copolymère statistique.

Les techniques DSA permettent de réaliser différents types de motifs dans un substrat de circuit intégré. Après dépôt et assemblage du copolymère à blocs sur le substrat, les motifs secondaires sont développés en retirant l'un des deux blocs du copolymère, par exemple le bloc A, sélectivement par rapport à l'autre, formant ainsi des motifs dans la couche restante de copolymère (le bloc B). Si les domaines du bloc A sont des cylindres, les motifs obtenus après retrait sont des trous cylindriques. Par contre, si les domaines du bloc A sont des lamelles, on obtient des motifs en forme de tranchée rectiligne. Puis, ces motifs sont transférés par gravure à la surface du substrat, soit directement dans une couche diélectrique, soit au préalable dans un masque dur recouvrant la couche diélectrique.

Le copolymère à blocs PMMA-b-PS, constitué de polyméthacrylate de méthyle (PMMA) et de polystyrène (PS), est le plus étudié dans la littérature. En effet, les synthèses de ce copolymère à blocs et du copolymère statistique correspondant (PMMA-r-PS) sont faciles à réaliser et parfaitement maîtrisées. Le retrait de la phase de PMMA peut être réalisé par une gravure humide, éventuellement couplée à une exposition aux ultraviolets, ou par une gravure sèche utilisant un plasma.

La gravure humide du PMMA, par exemple dans un bain d'acide acétique, est une technique de retrait hautement sélective par rapport au polystyrène. La sélectivité, c'est-à-dire le rapport de la vitesse de gravure du PMMA sur la vitesse de gravure du polystyrène, est élevée (supérieure à 20 : 1). Toutefois, avec cette technique, des résidus de gravure se redéposent sur la couche de copolymère gravée, bouchant une partie des motifs obtenus dans la couche de polystyrène ce qui empêche leur transfert. En outre, dans le cas de domaines en forme de lamelles, la gravure humide peut provoquer un effondrement des structures de polystyrène dû aux forces de capillarité importantes.

La gravure sèche au plasma ne souffre pas de ces inconvénients et présente un intérêt économique fort, car l'étape de transfert des motifs qui suit l'étape de retrait du PMMA est également une gravure par plasma. Par conséquent, le même équipement peut être utilisé successivement pour ces deux étapes. Les plasmas habituellement utilisés pour graver la phase de PMMA sont générés à partir d'un mélange d'argon et d'oxygène (Ar/O₂) ou d'un mélange d'oxygène et de gaz fluorocarboné (ex. O₂/CHF₃). La gravure du PMMA à l'aide de ces plasmas s'effectue toutefois avec une sélectivité par rapport au polystyrène bien inférieure à celle de la gravure humide (respectivement de 4,2 et 3,5).

Ainsi, d'autres plasmas ont été développés afin d'augmenter la sélectivité de la gravure (sèche) du PMMA. Par exemple, dans l'article [« Highly selective etch gas chemistry design for precise DSAL dry development process », M. Omura et al., Advanced Etch Technology for Nanopatterning III, Proc. SPIE Vol. 9054, 905409, 2014], les auteurs montrent qu'un plasma de monoxyde de carbone (CO) permet de graver le PMMA avec une sélectivité quasi-infinie. En effet, le PMMA est gravé par le plasma CO sans que le polystyrène ne soit impacté, car un dépôt carboné se forme simultanément sur le polystyrène.

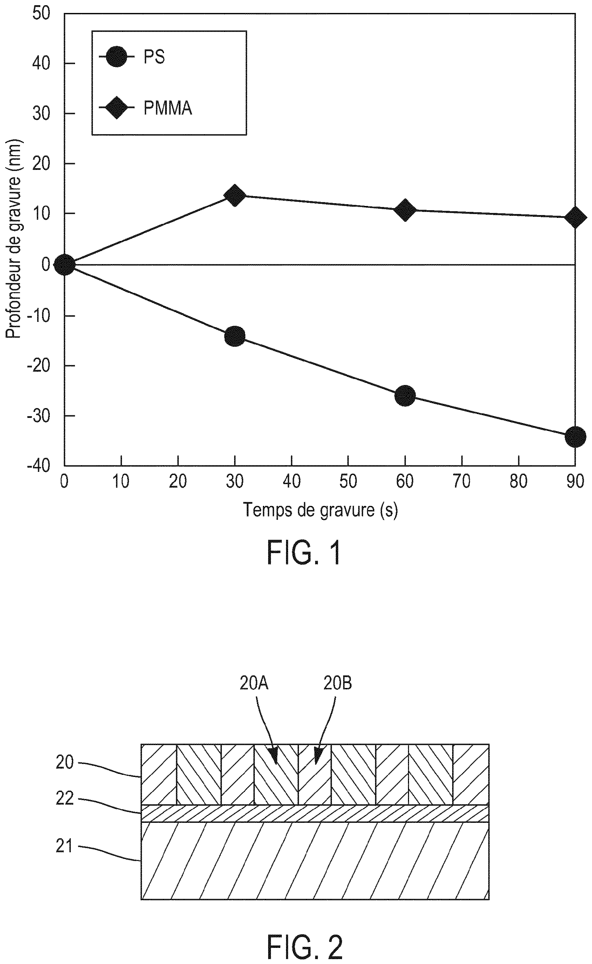

La figure 1 est un graphique qui représente la profondeur de gravure dans une couche de PMMA et dans une couche de polystyrène (PS) au cours de la gravure par le plasma CO. Elle illustre la différence de régimes entre les deux couches : régime de gravure dans le cas de la couche de PMMA (profondeur de gravure positive) et régime de dépôt dans le cas de la couche de PS (profondeur de gravure négative).

Lorsque ce gaz est utilisé seul, un phénomène de saturation se produit à environ 30 s de gravure, entraînant un arrêt de la gravure du PMMA. En effet, le régime de dépôt prend progressivement le dessus sur le régime de gravure et la gravure du PMMA est arrêtée à une profondeur de gravure d'environ 15 nm par la formation d'une couche carbonée sur la couche partiellement gravée de PMMA. Il n'est donc pas possible de graver plus de 15 nm d'épaisseur de PMMA avec ce seul gaz.

Pour remédier à ce problème de saturation, le monoxyde de carbone est mélangé à de l'hydrogène (H₂) en concentration inférieure ou égale à 7% et le plasma est généré à une puissance de polarisation d'environ 80 W. On constate dans la pratique que ce mélange de gaz présente une sélectivité de gravure bien inférieure à celle du monoxyde de carbone seul, car l'ajout d'hydrogène inhibe le dépôt de la couche carbonée sur le polystyrène. Le polystyrène est alors gravé en même temps que le PMMA. Il en résulte un élargissement des motifs formés dans la couche de polystyrène (par rapport aux dimensions initiales des domaines de PMMA) et des difficultés pour transférer ces motifs dans le substrat. En effet, la couche de polystyrène utilisée comme masque lors de ce transfert risque de ne pas être suffisamment épaisse.

### RÉSUMÉ DE L'INVENTION

La présente invention a pour but de repousser les limites de la gravure sèche d'un copolymère à blocs en termes de profondeur de gravure, tout en ayant une sélectivité de gravure élevée entre les phases ou blocs du copolymère.

Selon l'invention, on tend vers cet objectif en prévoyant un procédé de gravure d'une couche de copolymère à blocs assemblé comprenant des première et seconde phases de polymère, le procédé de gravure comportant :
- une première étape de gravure par un premier plasma formé à partir du monoxyde de carbone ou d'un premier mélange de gaz comprenant un gaz fluorocarboné et un gaz dépolymérisant, la première étape de gravure étant réalisée de façon à graver partiellement la première phase de polymère et à déposer une couche carbonée sur la deuxième phase de polymère ; et
- une deuxième étape de gravure par un deuxième plasma formé à partir d'un deuxième mélange de gaz comprenant un gaz dépolymérisant et un gaz choisi parmi les oxydes de carbone et les gaz fluorocarbonés, la deuxième étape de gravure étant réalisée de façon à graver la première phase de polymère et la couche carbonée sur la deuxième phase de polymère.

Le procédé selon l'invention combine ainsi une première étape de gravure, dont la sélectivité est quasiment infinie mais qui est limitée en termes de profondeur de gravure de la première phase de polymère, à une deuxième étape de gravure moins sélective mais permettant de graver davantage la première phase de polymère. La couche carbonée formée sur la deuxième phase de polymère lors de la première étape de gravure protège la deuxième phase lors de la deuxième étape de gravure. La couche carbonée sert de couche sacrificielle, car elle est consommée lors de la deuxième étape de gravure à la place de la deuxième phase de polymère. Ainsi, on parvient à s'affranchir du phénomène de saturation des plasmas à base de carbone tout en préservant une sélectivité de gravure élevée.

Cet enchaînement d'étapes constitue avantageusement un cycle de gravure, qui peut être reproduit plusieurs fois selon l'épaisseur à graver de la première phase de polymère. Le procédé de gravure ne connaît alors aucune limite en termes de profondeur de gravure.

Dans un mode de mise en oeuvre préférentiel du procédé selon l'invention, le premier plasma et le deuxième plasma sont formés en utilisant un même gaz de gravure autre que le gaz dépolymérisant. Le procédé de gravure est alors particulièrement simple à mettre en oeuvre.

Ce gaz de gravure peut être le monoxyde de carbone. Il est alors utilisé seul lors de la première étape de gravure et en combinaison avec un gaz dépolymérisant lors de la deuxième étape de gravure.

Ce gaz de gravure peut aussi être choisi parmi les gaz fluorocarbonés. Il est alors mélangé à un gaz dépolymérisant lors de chacune des première et deuxième étapes de gravure. La première étape de gravure présente avantageusement un rapport du débit de gaz fluorocarboné sur le débit de gaz dépolymérisant compris entre 0,8 et 1,2 et la deuxième étape de gravure présente avantageusement un rapport du débit de gaz fluorocarboné sur le débit de gaz dépolymérisant compris entre 0,3 et 0,7.

Le procédé selon l'invention peut également présenter une ou plusieurs des caractéristiques ci-dessous, considérées individuellement ou selon toutes les combinaisons techniquement possibles :
- la deuxième étape de gravure présente un rapport du débit d'oxyde de carbone sur le débit de gaz dépolymérisant compris entre 0,3 et 50 ;
- la première étape de gravure est réalisée dans des conditions telles que la couche carbonée est déposée uniquement sur la deuxième phase de polymère ;
- la première étape de gravure a une durée comprise entre 5 s et 30 s ;
- la première étape de gravure est réalisée dans des conditions telles que la couche carbonée est en outre déposée sur la première phase de polymère partiellement gravée, la couche carbonée ayant une épaisseur sur la première phase de polymère plus faible que sur la deuxième phase de polymère ;
- la deuxième étape de gravure a une durée comprise entre 5 s et 30 s ;
- la première phase de polymère est organique et présente une concentration en atomes d'oxygène supérieure à 20 %,
- la deuxième phase de polymère présente une concentration en atomes d'oxygène inférieure à 10 % ; et
- le gaz dépolymérisant du premier mélange et le gaz dépolymérisant du deuxième mélange sont choisis parmi H₂, N₂, O₂, Xe, Ar et He.

### BRÈVE DESCRIPTION DES FIGURES

D'autres caractéristiques et avantages de l'invention ressortiront clairement de la description qui en est donnée ci-dessous, à titre indicatif et nullement limitatif, en référence aux figures annexées, parmi lesquelles :
- la figure 1, précédemment décrite, représente la profondeur de gravure dans une couche de PMMA et dans une couche de polystyrène (PS) lors d'une gravure par un plasma de monoxyde de carbone ;
- la figure 2 représente un exemple de couche d'un copolymère à blocs assemblé avant la mise en oeuvre du procédé de gravure selon l'invention ;
- les figures 3A à 3D représentent l'évolution de la couche de copolymère de la figure 2 au cours de deux cycles de gravure successifs du procédé de gravure selon l'invention.

Pour plus de clarté, les éléments identiques ou similaires sont repérés par des signes de références identiques sur l'ensemble des figures.

### DESCRIPTION DÉTAILLÉE D'AU MOINS UN MODE DE RÉALISATION

La figure 2 montre une couche 20 de copolymère à blocs assemblé avant qu'elle ne soit gravée grâce au procédé de gravure selon l'invention. La couche de copolymère 20 comprend des première et deuxième phases de polymère, notées respectivement 20A et 20B, qui s'organisent en domaines. Le copolymère de la couche 20 est par exemple le copolymère di-bloc PS-*b*-PMMA, c'est-à-dire un copolymère constitué de polyméthacrylate de méthyle (PMMA) et de polystyrène (PS). La phase de polymère 20A correspond ici au PMMA et la phase de polymère 20B au polystyrène.

Une façon d'obtenir cette couche de copolymère à blocs 20 consiste à déposer le copolymère à blocs PS-*b*-PMMA sur un substrat 21 recouvert d'une couche de neutralisation 22. La couche de neutralisation 22 permet la séparation des phases 20A-20B lors de l'étape d'assemblage du copolymère à bloc, autrement dit l'organisation des domaines du copolymère. Elle est par exemple formée d'une couche de copolymère statistique PS-*r*-PMMA. De préférence, les domaines de PMMA (phase 20A) sont orientés perpendiculairement au substrat 21 et s'étendent sur toute l'épaisseur de la couche de copolymère 20. Suivant le ratio entre PMMA et polystyrène dans le copolymère PS-*b*-PMMA, les domaines de PMMA peuvent être en forme de cylindres (on parle alors de copolymère à blocs cylindrique) ou de lamelles (copolymère à blocs lamellaire).

Le procédé de gravure par plasma décrit ci-après vise à graver la phase du copolymère contenant le plus d'atomes d'oxygène, la phase de PMMA 20A dans l'exemple ci-dessus, sélectivement par rapport à l'autre phase, la phase de polystyrène 20B. A cette fin, il comporte deux étapes de gravure successives qui forment ensemble un cycle de gravure. Un seul cycle de gravure (i.e. une seule itération de chacune des étapes de gravure) peut ne pas suffire à graver entièrement la phase de PMMA 20A si l'épaisseur de la couche de copolymère 20 est trop importante. Dans ce cas, le procédé de gravure comporte avantageusement plusieurs cycles de gravure successifs, chaque cycle permettant de retirer une portion de la phase de PMMA et comprenant les deux étapes de gravure.

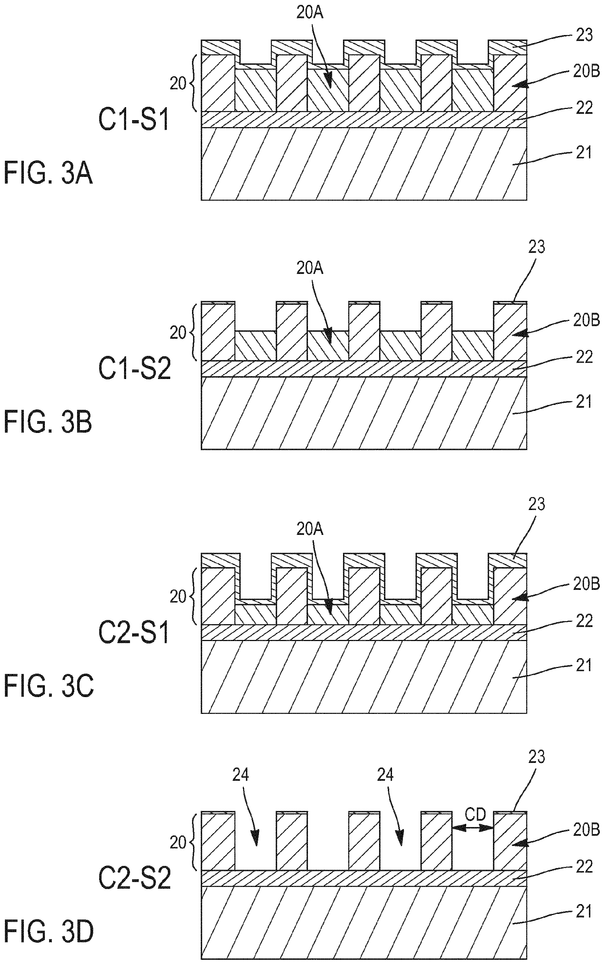

Les figures 3A et 3B représentent l'évolution de la couche de copolymère 20 au cours d'un premier cycle de gravure C1. Ce cycle C1 comprend une première étape de gravure S1 par plasma, au cours de laquelle la phase de PMMA 20A est partiellement gravée et la phase de polystyrène 20B est recouverte d'une couche carbonée 23 (Fig.3A). Il comprend en outre une deuxième étape de gravure S2, également par plasma, permettant de graver simultanément la phase de PMMA 20A et la couche carbonée 23 précédemment obtenue (Fig.3B). Les plasmas des étapes de gravure S1-S2 peuvent être formés dans un réacteur à couplage capacitif (CCP, pour « Capacitively Coupled Plasmas » en anglais) ou à couplage inductif (ICP, pour « Inductively Coupled Plasmas »).

Les conditions dans lesquelles est réalisée la première étape de gravure S1 peuvent être choisies de sorte que la couche carbonée 23 recouvre la phase de PMMA 20A en plus de la phase de polystyrène 20B, comme cela est illustré sur la figure 3A. La couche carbonée 23 obtenue possède toutefois une épaisseur sur la phase de PMMA 20A inférieure à celle sur la phase de polystyrène 20B, sans quoi il ne serait plus possible de graver le PMMA sans impacter le polystyrène lors de la deuxième étape de gravure S2.

Comme indiqué dans l'article [« Highly selective etch gas chemistry design for precise DSAL dry development process », M. Omura et al., Advanced Etch Technology for Nanopatterning III, Proc. SPIE Vol. 9054, 905409, 2014], un plasma de monoxyde carbone (CO) permet de réaliser simultanément une gravure partielle du PMMA et un dépôt carboné sur le polystyrène. Les ions de ce gaz détruisent les chaînes du polymère PMMA en consommant l'oxygène qu'elles contiennent. Ils sont également à l'origine de la formation de la couche carboné 23 sur le polystyrène, ce dernier étant insensible à la gravure car ne contenant pas d'oxygène.

Le plasma CO peut donc être utilisé lors de la première étape de gravure S1. Le débit de monoxyde de carbone entrant dans la chambre du réacteur est de préférence compris entre 100 sccm et 500 sccm (abréviation de « Standard Cubic Centimeter per Minute » en anglais, soit le nombre de cm³ de gaz s'écoulant par minute dans les conditions standard de pression et de température, i.e. à une température de 0 °C et une pression de 1013,25 hPa).

Alternativement, le plasma de la première étape S1 peut être généré à partir d'un mélange de gaz comprenant un ou plusieurs gaz fluorocarbonés (CₓF_{y}), éventuellement hydrogéné (CₓF_{y}H) ou iodé (CₓF_{y}I), et un gaz dépolymérisant, par exemple choisi parmi H₂, N₂, O₂, Xe, Ar, He... Le rôle du gaz dépolymérisant est de contrôler la quantité de polymères se formant lors de la réaction entre les espèces provenant du gaz de gravure et le matériau à graver. Sans ce gaz, un dépôt fluorocarboné se déposerait de façon significative sur les deux blocs du copolymère. Le débit de gaz fluorocarboné et le débit de gaz dépolymérisant lors de cette première étape de gravure S1 sont de préférence compris entre 10 sccm et 200 sccm. Le rapport du débit de gaz fluorocarboné sur le débit de gaz dépolymérisant est avantageusement compris entre 0,8 et 1,2, par exemple 1.

Les autres paramètres de la gravure plasma lors de la première étape S1 sont avantageusement les suivants, quelle que soit la nature du gaz de gravure utilisé (CO ou CₓF_{y}) :
- une puissance (RF) émise par la source du réacteur comprise entre 50 W et 500 W ;
- une puissance (DC ou RF) de polarisation du substrat comprise entre 50 W et 500 W;
- une pression dans la chambre du réacteur comprise 2,67 Pa (20 mTorr) et 16,00 Pa (120 mTorr).

Dans une variante de mise en oeuvre de la première étape S1 (non représentée), les conditions de la gravure sont telles que la couche carbonée 23 ne recouvre que la phase de polystyrène 20B. Dans les plages de puissance et de pression susmentionnées, cela peut être obtenue en jouant sur le temps de gravure. De préférence, la durée de la première étape de gravure S1 est comprise entre 5 s et 30 s. Ainsi, la phase de PMMA 20A est partiellement gravée sans que la couche carbonée 23 ne soit formée à sa surface. Autrement dit, sur le graphique de figure 1, on se place avant le seuil de saturation de la gravure, où le régime de gravure du PMMA prédomine. Ce mode de mise en oeuvre de l'étape de gravure S1 est le plus rapide et le plus économe en gaz.

A titre d'exemple, un plasma généré dans un réacteur CCP à partir de monoxyde de carbone (CO), avec un débit de 250 sccm, une puissance de source de 150 W, une puissance de polarisation de 50 W et une pression de 16,00 Pa (120 mTorr) permet de graver environ 13 nm de PMMA pendant 10 s et de déposer pendant le même laps de temps une couche carbonée d'environ 1 nm sur le polystyrène.

Un résultat sensiblement identique peut être obtenu en mélangeant dans le même type de réacteur du perfluorocyclobutane (C₄F₈) et du diazote (N₂), tous deux avec un débit de 25 sccm, et en appliquant une puissance de source de 300 W et une puissance de polarisation de 60 W sous une pression de 4,00 Pa (30 mTorr) pendant 20 s. En effet, une portion de PMMA de 10 nm d'épaisseur environ est retirée tandis qu'une couche carbonée de 1 nm d'épaisseur est déposée sur le polystyrène.

La deuxième étape de gravure S2, représentée à la figure 3B, permet de poursuivre la gravure de la phase de PMMA 20A en utilisant une chimie plus agressive vis-à-vis du PMMA, mais moins sélective par rapport à la phase de polystyrène 20B. Cette deuxième étape S2 permet donc de dépasser les limites de la première étape S1 en termes de profondeur de gravure. Le fait que la sélectivité PMMA/PS de la deuxième étape de gravure S2 soit faible est sans incidence, car la phase de polystyrène 20B est protégée par la couche carbonée 23.

Le gaz de gravure permettant de générer le plasma de la deuxième étape de gravure S2 est choisi parmi les oxydes de carbone (COₓ), par exemple CO ou CO₂, et les gaz fluorocarbonés (CₓF_{y}, CₓF_{y}H ou CₓF_{y}I). Son débit en entrée du réacteur (ICP ou CCP) est avantageusement compris entre 10 sccm et 500 sccm. Dans la chambre du réacteur, il est mélangé à un gaz dépolymérisant (H₂, N₂, O₂, Xe, Ar, He...) afin de contrôler le taux de polymérisation du matériau.

La sélectivité de ces chimies vis-vis de la couche carbonée 23 déposée lors de la première étape S1 est élevée, de l'ordre de 25. Pour remplir son rôle protecteur, la couche carbonée 23 peut donc être aussi fine que 1 nm d'épaisseur.

L'étape de gravure S2 est arrêtée au plus tard lorsque la phase de polystyrène 20B est découverte, c'est-à-dire lorsque la couche carbonée 23 est entièrement gravée. Sa durée est de préférence comprise entre 5 s et 30 s. La pression dans la chambre du réacteur lors de l'étape S2 est avantageusement comprise entre 2,67 Pa (20 mTorr) et 16,00 Pa (120 mTorr). Les puissances de source et de polarisation peuvent être les mêmes que lors de l'étape S1 (50-500 W).

A titre d'exemple, le plasma de l'étape S2 est généré dans un réacteur CCP en mélangeant du monoxyde de carbone (CO) et de l'hydrogène (H₂), tous deux avec un débit de 250 sccm, et en appliquant une puissance de source de 150 W et une puissance de polarisation de 50 W sous une pression de 16,00 Pa (120 mTorr) pendant 20 s. Une nouvelle portion de PMMA de 25 nm d'épaisseur environ est ainsi retirée. La couche carbonée de 1 nm d'épaisseur obtenue à l'étape S1 est entièrement consommée, sans toutefois que le polystyrène ne soit gravé.

Le gaz dépolymérisant utilisé à la deuxième étape S2 peut être différent de celui (éventuellement) utilisé à la première étape S1, en combinaison avec le gaz fluorocarboné. Toutefois, dans un souci de simplification du procédé de gravure, le même gaz dépolymérisant est avantageusement utilisé lors des deux étapes.

Pour les mêmes raisons, le gaz de gravure utilisé à la première étape S1 est dans un mode de mise en oeuvre préférentiel du procédé de gravure le même que celui utilisé à la deuxième étape S2. Ainsi, lorsque le monoxyde de carbone est employé (seul) à l'étape S1, il fait partie du mélange de gaz utilisé à l'étape S2. Le rapport du débit de monoxyde de carbone sur le débit de gaz dépolymérisant lors de la deuxième étape S2 est avantageusement compris entre 0,3 et 50. De la même façon, si le choix du gaz de gravure pour la première étape S1 porte sur un gaz fluorocarboné, il peut être maintenu pour la deuxième étape S2. La différence de comportement des plasmas vis-vis de la couche carbonée 23 entre les deux étapes S1-S2 (i.e. dépôt puis gravure) est alors due à des ratios de gaz différents entre les deux mélanges. Lors de la deuxième étape de gravure S2, le rapport du débit de gaz fluorocarboné sur le débit de gaz dépolymérisant est avantageusement compris entre 0,3 et 0,7 (0,8-1,2 lors de la première étape S1).

Les étapes de gravure S1-S2 étant indépendantes l'une de l'autre, rien n'empêche qu'elles soient réalisées avec des gaz de gravure appartenant à des familles différentes (monoxyde de carbone d'une part et gaz fluorocarboné d'autre part), ou en choisissant des gaz de natures différentes dans une même famille (par exemple C₄F₆ d'une part et C₄F₈ d'autre part). Diverses combinaisons de gaz sont ainsi possibles entre les étapes S1 et S2 du procédé.

A la fin du cycle de gravure C1, la phase de PMMA 20A a été gravée sur une épaisseur plus importante que si elle avait été gravée avec le procédé de l'art antérieur, c'est-à-dire lors d'une seule étape de gravure au plasma CO. Lorsqu'il subsiste une portion de la phase de PMMA 20A à la fin du premier cycle de gravure C1, comme cela est illustré sur la figure 3B, le procédé comporte au moins un nouveau cycle de gravure comprenant les étapes S1 et S2. Les paramètres de gravure des étapes S1 et S2 sont avantageusement les mêmes d'un cycle de gravure à l'autre.

Les figures 3C et 3D représentent respectivement les étapes S1 et S2 d'un deuxième cycle de gravure C2 initié immédiatement après la fin du premier cycle de gravure C1. A l'étape S1 (Fig.3C), la couche carbonée 23 est à nouveau formée sur la phase de polystyrène 20B (et éventuellement sur la phase restante de PMMA 20A), avant d'être consommée lors de l'étape S2. Lors de chacune des étapes S1-S2 du cycle C2, la phase de PMMA 20A est à nouveau gravée.

Dans l'exemple des figures 3A-3D, deux cycles de gravure C1-C2 suffisent à graver entièrement la phase de PMMA 20A de la couche de copolymère à blocs 20. Des motifs 24 sont alors apparents dans la couche restante de copolymère, désormais composée uniquement de la phase de polystyrène 20B (Fig.3D). La phase de polystyrène 20B n'est quasiment pas gravée lors de ce procédé de gravure. Divers essais ont été menés et montrent que la phase PMMA d'une couche de copolymère PS-*b*-PMMA de 50 nm d'épaisseur peut être gravée en deux cycles successifs C1-C2 en consommant moins d' 1 nm de polystyrène. La sélectivité PMMA/PS du procédé de gravure, moyennée sur les deux étapes S1 et S2, est donc de 50 environ.

Il est préférable, lors de la deuxième étape de gravure S2 de chaque cycle, de ne pas graver entièrement la couche carbonée 23 (cf. Figs.3B, 3D), car la phase de polystyrène 20B peut être gravée de façon superficielle pendant les premières secondes de l'étape S1 du cycle suivant, i.e. le temps que se forme la couche carbonée 23. La couche carbonée 23 peut subsister même après la deuxième étape S2 du dernier cycle de gravure. Elle vient alors renforcer la couche de polystyrène qui servira de masque pour le transfert des motifs 24 dans le substrat 21 (après ouverture de la couche de neutralisation 22).

Comme la vitesse de dépôt et la vitesse de gravure de la couche carbonée 23 (respectivement lors de la première étape de gravure S1 et de la deuxième étape de gravure S2) peuvent être déterminées facilement, et éventuellement ajustées en jouant sur les paramètres de chaque gravure, il est possible de contrôler l'épaisseur de la couche carbonée 23, notamment sur les flancs des motifs 24 obtenus par la gravure de la phase de PMMA 20A. Le procédé de gravure des figures 3A-3D assure ainsi un meilleur contrôle de la dimension critique CD des motifs 24 (cf. Fig.3D). Par dimension critique, on entend la plus petite dimension des motifs 24 obtenus par le développement du copolymère à blocs.

Bien qu'il ait été décrit en prenant le copolymère PS-*b*-PMMA en exemple, le procédé de gravure selon l'invention est applicable à tous copolymères à blocs comprenant une première phase de polymère organique (20A) riche en oxygène, c'est-à-dire ayant une concentration en atomes d'oxygène supérieure à 20 %, et une deuxième phase de polymère (organique ou inorganique) pauvre en oxygène, i.e. ayant une concentration en atomes d'oxygène inférieure à 10%. C'est le cas notamment des copolymères di-blocs PS-*b*-PLA, PDMS-b-PMMA, PDMS-b-PLA, PDMSB-*b*-PLA, etc. Le copolymère à blocs peut être soit de type cylindrique, soit de type lamellaire.

Enfin, la couche de copolymère à blocs organisé peut évidemment être obtenue d'une manière différente de celle décrite ci-dessus en relation avec la figure 2, notamment par grapho-épitaxie, par chemo-épitaxie en utilisant une couche de neutralisation autre qu'un copolymère statistique (par exemple une monocouche auto-assemblée, SAM), ou par une technique hybride mêlant grapho-épitaxie et chémo-épitaxie.

## Revendications

1. Procédé de gravure d'une couche (20) de copolymère à blocs assemblé comprenant des première et seconde phases de polymère (20A-20B), le procédé de gravure comportant une première étape de gravure (S1) par un premier plasma formé à partir du monoxyde de carbone ou d'un premier mélange de gaz comprenant un gaz fluorocarboné et un gaz dépolymérisant, la première étape de gravure étant réalisée de façon à graver partiellement la première phase de polymère (20A) et à déposer une couche carbonée (23) sur la deuxième phase de polymère (20B) ;
le procédé de gravure étant **caractérisé en ce qu'**il comporte une deuxième étape de gravure (S2) par un deuxième plasma formé à partir d'un deuxième mélange de gaz comprenant un gaz dépolymérisant et un gaz choisi parmi les oxydes de carbone et les gaz fluorocarbonés, la deuxième étape de gravure étant réalisée de façon à graver la première phase de polymère (20A) et la couche carbonée (23) sur la deuxième phase de polymère (20B).

2. Procédé selon la revendication 1, comprenant une pluralité de cycles de gravure successifs (C1, C2), chaque cycle de gravure comprenant successivement la première étape de gravure (S1) et la deuxième étape de gravure (S2).

3. Procédé selon l'une des revendications 1 et 2, dans lequel le premier plasma et le deuxième plasma sont formés en utilisant un même gaz autre que le gaz dépolymérisant.

4. Procédé selon la revendication 3, dans lequel le deuxième mélange comprend du monoxyde de carbone.

5. Procédé selon la revendication 3, dans lequel la première étape de gravure (S1) présente un rapport du débit de gaz fluorocarboné sur le débit de gaz dépolymérisant compris entre 0,8 et 1,2 et dans lequel la deuxième étape de gravure (S2) présente un rapport du débit de gaz fluorocarboné sur le débit de gaz dépolymérisant compris entre 0,3 et 0,7.

6. Procédé selon l'une quelconque des revendications 1 à 5, dans lequel la deuxième étape de gravure (S2) présente un rapport du débit d'oxyde de carbone sur le débit de gaz dépolymérisant compris entre 0,3 et 50.

7. Procédé selon l'une quelconque des revendications 1 à 6, dans lequel la première étape de gravure (S1) est réalisée dans des conditions telles que la couche carbonée (23) est déposée uniquement sur la deuxième phase de polymère (20B).

8. Procédé selon la revendication 7, dans lequel la première étape de gravure (S1) a une durée comprise entre 5 s et 30 s.

9. Procédé selon l'une quelconque des revendications 1 à 6, dans lequel la première étape de gravure (S1) est réalisée dans des conditions telles que la couche carbonée (23) est en outre déposée sur la première phase de polymère (20A) partiellement gravée, la couche carbonée ayant une épaisseur sur la première phase de polymère (20A) plus faible que sur la deuxième phase de polymère (20B).

10. Procédé selon l'une quelconque des revendications 1 à 9, dans lequel la deuxième étape de gravure (S2) a une durée comprise entre 5 s et 30 s.

11. Procédé selon l'une quelconque des revendications 1 à 10, dans lequel la première phase de polymère (20A) est organique et présente une concentration en atomes d'oxygène supérieure à 20 %, et dans lequel la deuxième phase de polymère (20B) présente une concentration en atomes d'oxygène inférieure à 10 %.

12. Procédé selon l'une quelconque des revendications 1 à 11, dans lequel le gaz dépolymérisant du premier mélange et le gaz dépolymérisant du deuxième mélange sont choisis parmi H₂, N₂, O₂, Xe, Ar et He.

## Patentansprüche

1. Ätzverfahren einer Schicht (20) aus zusammengesetztem Block-Copolymer, umfassend erste und zweite Polymerphasen (20A-20B), wobei das Ätzverfahren einen ersten Ätzschritt (S1) durch ein erstes Plasma umfasst, das ausgehend von Kohlenstoffmonoxid oder einer ersten Gasmischung gebildet ist, umfassend ein fluorkohlenstoffhaltiges Gas und ein entpolymerisierendes Gas, wobei der erste Ätzschritt derart realisiert ist, dass die erste Polymerphase (20A) teilweise geätzt ist und eine kohlenstoffhaltige Schicht (23) auf der zweiten Polymerphase (20B) aufgebracht ist
wobei das Ätzverfahren **dadurch gekennzeichnet ist, dass** es einen zweiten Ätzschritt (S2) durch ein zweites Plasma umfasst, das ausgehend von einer zweiten Gasmischung gebildet ist, umfassend ein entpolymerisierendes Gas und ein Gas, das auch Kohlenstoffoxiden und fluorkohlenstoffhaltigen Gasen ausgewählt ist, wobei der zweite Ätzschritt derart realisiert ist, dass die erste Polymerphase (20A) und die kohlenstoffhaltige Schicht (23) auf der zweiten Polymerphase (20B) geätzt sind.

2. Verfahren gemäß Anspruch 1, umfassend eine Vielzahl von sukzessiven Ätzzyklen (C1, C2), wobei jeder Ätzzyklus sukzessive den ersten Ätzschritt (S1) und den zweiten Ätzschritt (S2) umfasst.

3. Verfahren gemäß einem der Ansprüche 1 und 2, bei dem das erste Plasma und das zweite Plasma durch Verwenden eines und desselben Gases gebildet sind, das nicht das entpolymerisierende Gas ist.

4. Verfahren gemäß Anspruch 3, bei dem die zweite Mischung Kohlenmonoxid umfasst.

5. Verfahren gemäß Anspruch 3, bei dem der erste Ätzschritt (S1) ein Verhältnis des Durchsatzes an fluorkohlenstoffhaltigem Gas zu dem Durchsatz an entpolymerisierendem Gas aufweist, der zwischen 0,8 und 1,2 inbegriffen ist und bei dem der zweite Ätzschritt (S2) ein Verhältnis des Durchsatzes an fluorkohlenstoffhaltigem Gas zu dem Durchsatz an entpolymerisierendem Gas aufweist, der zwischen 0,3 und 0,7 inbegriffen ist.

6. Verfahren gemäß irgendeinem der Ansprüche 1 bis 5, bei dem der zweite Ätzschritt (S2) ein Verhältnis des Durchsatzes an Kohlenstoffoxid zum Durchsatz an entpolymerisierendem Gas aufweist, das zwischen 0,3 und 50 inbegriffen ist.

7. Verfahren gemäß irgendeinem der Ansprüche 1 bis 6, bei dem der erste Ätzschritt (S1) unter derartigen Bedingungen realisiert ist, dass die kohlenstoffhaltige Schicht (23) nur auf der zweiten Polymerphase (20B) aufgebracht ist.

8. Verfahren gemäß Anspruch 7, bei dem der erste Ätzschritt (S1) eine zwischen 5 Sek. und 30 Sek. inbegriffene Dauer hat.

9. Verfahren gemäß irgendeinem der Ansprüche 1 bis 6, bei dem der erste Ätzschritt (S1) unter derartigen Bedingungen realisiert ist, dass die kohlenstoffhaltige Schicht (23) darüber hinaus auf der teilweise geätzten ersten Polymerphase (20A) aufgebracht ist, wobei die kohlenstoffhaltige Schicht eine Dicke auf der ersten Polymerphase (20A) aufweist, die dünner ist als die zweite Polymerphase (20B).

10. Verfahren gemäß irgendeinem der Ansprüche 1 bis 9, bei dem der zweite Ätzschritt (S2) eine zwischen 5 Sek. und 30 Sek. inbegriffene Dauer aufweist.

11. Verfahren gemäß irgendeinem der Ansprüche 1 bis 10 bei dem die erste Polymerphase (20A) organisch ist und eine Konzentration an Sauerstoffatomen von mehr als 20 % aufweist und bei dem die zweite Polymerphase (20B) eine Konzentration an Sauerstoffatomen von weniger als 10 % aufweist.

12. Verfahren gemäß irgendeinem der Ansprüche 1 bis 11, bei dem das entpolymerisierende Gas der ersten Mischung und das entpolymerisierende Gas der zweiten Mischung aus H₂, N₂, O₂, Xe, Ar und He ausgewählt sind.

## Claims

1. Method for etching an assembled block copolymer layer (20) comprising first and second polymer phases (20A-20B), the etching method comprising a first step of etching (S1) by a first plasma formed from carbon monoxide or a first gas mixture comprising a fluorocarbon gas and a depolymerising gas, the first etching step being carried out so as to partially etch the first polymer phase (20A) and to deposit a carbon layer (23) on the second polymer phase (20B);
the etching method being **characterised in that** it comprises a second step (S2) of etching by a second plasma formed from a second gas mixture comprising a depolymerising gas and a gas selected among the carbon oxides and the fluorocarbon gases, the second etching step being carried out so as to etch the first polymer phase (20A) and the carbon layer (23) on the second polymer phase (20B).

2. Method according to claim 1, comprising a plurality of successive etching cycles (C1, C2), each etching cycle successively comprising the first etching step (S1) and the second etching step (S2).

3. Method according to one of claims 1 and 2, wherein the first plasma and the second plasma are formed using a same gas other than the depolymerising gas.

4. Method according to claim 3, wherein the second mixture comprises carbon monoxide.

5. Method according to claim 3, wherein the first etching step (S1) has a ratio of the flow rate of fluorocarbon gas over the flow rate of depolymerising gas comprised between 0.8 and 1.2 and wherein the second etching step (S2) has a ratio of the flow rate of fluorocarbon gas over the flow rate of depolymerising gas comprised between 0.3 and 0.7.

6. Method according to any of claims 1 to 5, wherein the second etching step (S2) has a ratio of the flow rate of carbon oxide over the flow rate of depolymerising gas comprised between 0.3 and 50.

7. Method according to any of claims 1 to 6, wherein the first etching step (S1) is carried out in conditions such that the carbon layer (23) is only deposited on the second polymer phase (20B).

8. Method according to claim 7, wherein the first etching step (S1) has a duration comprised between 5 s and 30 s.

9. Method according to any of claims 1 to 6, wherein the first etching step (S1) is carried out in conditions such that the carbon layer (23) is further deposited on the first partially etched polymer phase (20A), the carbon layer having a thickness on the first polymer phase (20A) lower than on the second polymer phase (20B).

10. Method according to any of claims 1 to 9, wherein the second etching step (S2) has a duration comprised between 5 s and 30 s.

11. Method according to any of claims 1 to 10, wherein the first polymer phase (20A) is organic and has a concentration of oxygen atoms greater than 20 %, and wherein the second polymer phase (20B) has a concentration of oxygen atoms less than 10 %.

12. Method according to any of claims 1 to 11, wherein the depolymerising gas of the first mixture and the depolymerising gas of the second mixture are selected from H₂, N₂, O₂, Xe, Ar and He.
